# EUROPEAN PATENT APPLICATION

(11) **EP 3 367 296 A1**
(43) Date of publication of application: **29.08.2018**
(21) Application number: 17158562.3
(22) Date of filing: 28.02.2017
(51) Int. Cl.: G06K 9/00, G06F 17/50

(54) **A COMPUTER-IMPLEMENTED METHOD OF IDENTIFYING A PERFORATED FACE IN A GEOMETRICAL THREE-DIMENSIONAL MODEL**

(71) Applicant: Fujitsu Limited, Kanagawa 211-8588 (JP)
(72) Inventor: GEORGESCU, Serban, London, Greater London W5 3JY (GB); CHOW, Peter, Gillingham, Kent ME7 3AH (GB)
(74) Representative: Haseltine Lake LLP

(57) **Abstract**

A computer-implemented method of identifying a perforated face in a geometrical three-dimensional, 3D, model, the method comprising: obtaining two-dimensional, 2D, representations of faces of the model; creating a face image representing a rendering of each of the faces in 2D representation; comparing the face image to labelled perforation images in a neural network; and using the comparison to detect any perforations and classify the face image as belonging to one of: a perforated and a non-perforated face.

## Description

The present invention relates to computer-aided design and engineering. In particular it relates to identification of perforations in a three-dimensional, 3D, model of an object in a computer or digital environment.

The invention may also relate to potential adaptation of the model, in order to render that model more suitable for analysis of its structure and properties. Some invention embodiments relate specifically to detection and simplification of patterned holes of any shape or openings, and are useful in model modification followed by simulation (e.g. for structural analysis, or for thermal fluid dynamics). The target application may be 3-dimensional simulation software which is used in the development of manufacturing products.

This model modification process is most commonly found in design and manufacturing processes. For example, an engineer may design a product prototype in the form of a 3-dimensional component or complex part using a model in a CAD (computer-aided design) package such as AUTO CAD or Pro/ENGINEER and then wish to test the model for suitability of use. Such analysis of the virtual prototype/model may be required for specification requirements such as durability, health and safety demands and manufacturability. The design engineer may for instance wish to analyse the model in simulations to determine heat resistance, propagation of electromagnetic or other fields or stress-strain properties. This simulation process can refine product design without entailing the cost of actual manufacture and physical test. However, it is often necessary to modify the model so that it is simplified and can be more easily analysed.

One particular application of a modification process for a geometric model is in simplification of architectural models of buildings, for example for providing/improving airflow or ventilation or for fire simulation. Modification before airflow and thermal cooling simulation of models for heat producing electronic devices such as computer servers and mobile communications devices is a further, specific application. A still further application is in grilles used at the front of vehicles in the automotive sector.

Recently, 3-dimensional (3-D) numerical simulation technologies (such as structure analysis or computational fluid dynamics (CFD)) have been generalized to help design and develop industrial products. Use of such techniques is associated with the growth of simulation technologies and computational power. When a 3-D simulation model is prepared, geometry data may be provided from 3D-CAD data. However, geometry data in 3D-CAD is generally too complex to use for 3-dimensional numerical simulation without modification. Therefore, geometry data in 3D-CAD is usually simplified for the reduction of computational scale. Simplification in CAD-to-CAE model preparation (CCMP) significantly reduces the model size (in terms of electronic storage) and prepares the model for various classes of analysis. Models usually require preparation in form of modification (sometimes known as defeaturing) to make them suitable for analysis/simulation. Until recently the CCMP stage has been labour intensive and largely a manual process. With the development of computer-aided tools that automatically detect and process features, efficiency has significantly improved.

The subsequent step in model set up after geometry simplification/modification is mesh generation. A mesh model consists of vertices, edges, and faces that use polygonal representation, with polygons such as triangles and quadrilaterals making up each surface, to define a 3D shape using a multitude of small polygons. Automatic and fast mesh generation is available for both structured (finite difference) and unstructured (finite element) meshes. Usually, much simpler meshes can be used for simplified models.

A first process in geometry modification may be feature detection. In this first process, blend and chamfer faces, for example, are detected, and then these faces are deleted (and replaced with faces that give a simpler profile).

Another modification process may relate to parts with patterns of perforation (regular or consistent arrays of through holes or openings, which may be of any shape(s)). A porous medium, such as a perforated sheet or other product which requires cooling may for example be used at an inlet or outlet in a product model for many ICT (information and communication technology) products such as for a server, laptop PC or storage system. When the porous medium is simplified, through-holes or openings (referred to herein simply as holes) are detected.

Executing thermal airflow analysis or simulation is part of the computer-aided engineering (CAE) design and development process for ICT and other products. Using perforated part geometry without modification requires fine meshes and complex setting of flow-rate conditions for each of the perforated holes next to the external boundaries defining the domain perimeter. Fine meshes lead to high computing resource demand and long analysis time. Moreover, setting conditions for individual perforated holes is extremely inefficient.

In thermal airflow/airflow and other analysis, one advantageous practice is therefore to treat the perforated region as a single porous region, with porosity based on an aperture ratio of perforations (void) to total area/volume of the part. Porosity is often expressed as this ratio between 0 and 1 or the equivalent percentage between 0% and 100%.

This greatly simplifies the geometry (from perforated to non-perforated) and minimises the required boundary and/or internal condition setting. The change to a porous equivalent usually has no significant impact on solution accuracy and is very efficient.

EP2705450 discloses a method for identifying a group of perforations and converting the perforated region into a single porous region by replacing a perforated part with a solid part of the same shape but having a porosity value (for example below 100%) added, to have the same effect on airflow as the removed perforations. EP3002694 takes the technology as step further, by additionally considering incomplete perforations forming edges of a part. The content of these publications is incorporated herein by reference.

Another target application for the present invention may be in technical part retrieval. Users such as a designer or engineer may look for a part (perforated sheet) based on an existing part (broken or otherwise) or photo, without knowing the part ID or other information to search a catalogue or database for parts that are the same or similar as a potential replacement. This intended use is thus for a 3D shape part catalogue search e.g. for automotive parts using a captured image.

A further application for 3D shape search is prediction of manufacturing cost for an automated price quote and perhaps also delivery time. This process can be based on retrieving similar shapes and using the nearest N number similar shapes in a derived formula (such as higher weighting for the most similar) to calculate a cost.

According to an embodiment of a first aspect of the invention there is provided a computer-implemented method of identifying a perforated face in a geometrical three-dimensional, 3D, model, the method comprising: obtaining two-dimensional, 2D, representations of faces of the model; creating a face image representing a rendering of each of the faces in 2D representation; comparing the face image to labelled perforation images in a neural network; and using the comparison to detect any perforations and classify the face image as belonging to one of: a perforated and a non-perforated face (and thus identifying a perforated face).

Use of a neural network, such as a convolutional neural network, allows detection of perforations in a simple and effective manner which is not reliant on using analytical CAD definitions to recognise a perforation and which does not require new code to add new types of perforation for detection.

The method may further include categorising the geometrical type and/or arrangement of perforations of a perforated face using the neural network. This allows detection of particular perforations and/or patterns of perforation. The categorisation may take place at the same time as classification of the face image, but it can save time and computing resources if it is carried out after classification.

The method may include selecting any part in the model including a face classified as perforated. This allows perforated parts to be separated from non-perforated parts. The method may then retrieve features of the perforated parts, such as any of part geometry, part manufacturing cost, part delivery time and part identification. The part geometry and/or identification may simply be viewed during a search by a user. The manufacturing cost and/or delivery time may be used for calculating either or both of manufacturing cost and delivery time for a new perforated part, perhaps in combination with the same factor(s) for other perforated parts. The method may compare face images of a new perforated part with face images of known parts with known manufacturing cost and/or delivery time and use similarities between the new perforated parts and known parts to estimate manufacturing cost and/or delivery time,

The method may be used for a model which is represented using triangulated CAD data, in which case the 2D representations are created via fitting to an analytical function. The method may be used for a model which is represented using analytical CAD data, in which case the 2D representations are provided by a CAD kernel.

The model may be made up of parts and a part filter may then eliminate parts that are unsuited (in terms of size or definition, for example) to including perforated regions, before any 2D images of faces are obtained.

There may also be a face filter that eliminates faces that are unsuited (again perhaps in terms of size) to including perforated regions before any 2D images of faces are obtained.

An original face image (for instance above a predetermined size) may be partitioned into face region images which are compared to the labelled perforation images. In this case, a face, and hence a part including that face, is classified as perforated if any region of that face is classified as perforated.

Any suitable method of providing a face image may be used. A face image may be taken by a rendering camera from a position along the normal to the centre of the face image of the model of a physical object of interest. In this case, the rendering camera is positioned so that the entire face image fits into the field of view of the camera.

A further face image may be taken at a different position along the normal to capture perforations of a different size. This is for the case in which the camera may be too close or too far away to see the perforation(s) clearly. For example, if the size of the holes is very large, a camera placed close to the surface may not see clearly the perforated patterns, however a camera placed further away on the normal would be able to produce an image of a wider area, where the pattern will be clearer.

The method may include simplifying the geometrical three-dimensional, 3D, model including perforations, by, for a perforated face identified by classification of the face image, replacing the face in the 3D model with a solid face by removing the perforations. Correspondingly, a face region corresponding to a face region image which is classified as perforated may be replaced by a solid face region by removing the perforations.

Hence, embodiments of the invention may provide a computer-implemented method of simplifying a geometrical three-dimensional, 3D, model including perforations, by replacing a perforated face with a solid face, the method comprising: obtaining two-dimensional, 2D, representations of faces of the model; creating a face image representing a rendering of each of the faces in 2D representation; comparing the face image to labelled perforation images in a neural network to classify the face image as belonging to one of: a perforated and a non-perforated face; for a perforated face identified by classification of the face image, replacing the face in the 3D model with a solid face by removing the perforations.

The perforations may be removed using bounding boxes. For example each perforation on the face (or face image) may be surrounded by a bounding box (in two dimensions only) and the bounding boxes may be increased in size by an offset factor, which adjusts the highest and lowest extent of the bounding boxes equally and oppositely in at least one of mutually perpendicular directions (such as u and v surface coordinate directions).

The offset factor makes at least two of the separate bounding boxes overlap; then a united set of all the bounding boxes is created, overlapping separate bounding boxes becoming a single combined bounding box; the size of each bounding box in the united set is reduced by the scaling factor; and the one or more individual bodies formed by the one or more reduced-size bounding boxes are extracted from the united set, each individual body potentially representing a group of perforations.

The solid face may be given a porosity value in place of the perforations.

Embodiments of the invention may provide a computer-implemented method of analysing a geometrical three-dimensional, 3D, model including carrying out the method described above, including the simplifying step to remove the perforations and then analysing the simplified model using a numerical technique to determine physical results of the model shape, such as thermal, mechanical, or electro-magnetic properties, or airflow around and/or through the model.

According to an embodiment of a second aspect of the invention there is provided an apparatus configured to identify a perforated face in a geometrical three-dimensional, 3D, model, the apparatus comprising one or more processors and a memory, the one or more processors configured to: obtain two-dimensional, 2D, representations of faces of the model; create a face image representing a rendering of each of the faces in 2D representation; compare the face image to labelled perforation images stored in the memory using a neural network; and use the comparison to detect any perforations and to classify the face image as belonging to one of: a perforated and a non-perforated face.

According to an embodiment of a third aspect of the invention there is provided a computer program which when executed carries out a computer-implemented method of identifying a perforated face in a geometrical three-dimensional, 3D, model, the method comprising: obtaining two-dimensional, 2D, representations of faces of the model; creating a face image representing a rendering of each of the faces in 2D representation; comparing the face image to labelled perforation images in a neural network; and using the comparison to detect any perforations and classify the face image as belonging to one of: a perforated and a non-perforated face.

According to an embodiment of a fourth aspect of the invention there is provided a non-transitory computer-readable medium storing a computer program as described above.

An apparatus or computer program according to preferred embodiments of the present invention may comprise any combination of the method aspects. Methods or computer programs according to further embodiments may be described as computer-implemented in that they require processing and memory capability.

The apparatus according to preferred embodiments is described as configured or arranged to, or simply "to" carry out certain functions. This configuration or arrangement could be by use of hardware or middleware or any other suitable system. In preferred embodiments, the configuration or arrangement is by software.

Thus according to one aspect there is provided a program which, when loaded onto at least one computer configures the computer to become the apparatus according to any of the preceding apparatus definitions or any combination thereof.

According to a further aspect there is provided a program which when loaded onto the at least one computer configures the at least one computer to carry out the method steps according to any of the preceding method definitions or any combination thereof.

In general the computer may comprise the elements listed as being configured or arranged to provide the functions defined. For example this computer may include memory, processing, and a network interface.

The invention may be implemented in digital electronic circuitry, or in computer hardware, firmware, software, or in combinations of them. The invention may be implemented as a computer program or computer program product, i.e., a computer program tangibly embodied in a non-transitory information carrier, e.g., in a machine-readable storage device, or in a propagated signal, for execution by, or to control the operation of, one or more hardware modules.

A computer program may be in the form of a stand-alone program, a computer program portion or more than one computer program and may be written in any form of programming language, including compiled or interpreted languages, and it may be deployed in any form, including as a stand-alone program or as a module, component, subroutine, or other unit suitable for use in a data processing environment. A computer program may be deployed to be executed on one module or on multiple modules at one site or distributed across multiple sites and interconnected by a communication network.

Method steps of the invention may be performed by one or more programmable processors executing a computer program to perform functions of the invention by operating on input data and generating output. Apparatus of the invention may be implemented as programmed hardware or as special purpose logic circuitry, including e.g., an FPGA (field programmable gate array) or an ASIC (application-specific integrated circuit).

Processors suitable for the execution of a computer program include, by way of example, both general and special purpose microprocessors, and any one or more processors of any kind of digital computer. Generally, a processor will receive instructions and data from a read-only memory or a random access memory or both. The essential elements of a computer are a processor for executing instructions coupled to one or more memory devices for storing instructions and data.

The invention is described in terms of particular embodiments. Other embodiments are within the scope of the following claims. For example, the steps of the invention may be performed in a different order and still achieve desirable results.

Elements of the invention have been described using the terms "memory", "processor", etc. The skilled person will appreciate that such terms and their equivalents may refer to parts of the system that are spatially separate but combine to serve the functions defined. Equally, the same physical parts of the system may provide two or more of the functions defined.

For example, separately defined means may be implemented using the same memory and/or processor as appropriate.

Preferred features of the present invention will now be described, purely by way of example, with references to the accompanying drawings, in which:-
Figure 1 is a flow chart of a method in a general embodiment;
Figure 2 is a block diagram of main system components in a general embodiment of the invention
Figure 3 is a diagram of different types of perforation;
Figure 4 is a flowchart giving an overview of perforation detection;
Figure 5 is a flowchart of an outline of processing in a system implementing invention embodiments;
Figure 6 is a flowchart of a process for analysing each face not eliminated by two filters;
Figure 7 is an example of partitioning a triangulated face into 4 regions;
Figure 8 is a flowchart illustrating an approach taken for classification of a region as perforated/non-perforated and according to the type of perforation;
Figure 9 is a flowchart of the process for creating images from the geometry of an image;
Figure 10 is a view of a server model;
Figure 11 shows examples of components eliminated by a component filter;
Figure 12 shows a part remaining for processing after elimination of unsuitable components;
Figure 13 shows a CAD face to be analysed from the remaining part of Figure 12;
Figure 14 shows the CAD face of Figure 13 divided into 2 regions;
Figure 15 shows images of the regions of Figure 13; and
Figure 16 is a hardware diagram illustrating hardware used to implement invention embodiments.

The need to detect perforated sheets arises in domains such as Computer Aided Engineering (CAE) where, in order to simplify the model to be analysed, perforated regions are removed and/or replaced with regions of porosity. By removing such very small features, the complexity of the mesh and thus the amount of computation required can be greatly reduced. Traditionally, rule-based systems have been used for this purpose, such as those in EP2705450 and EP3002694, which use the shape definitions in a CAD model to detect perforations.

In recent years, the large amount of cheap computing power and labelled data (especially images) have resulted in neural networks (particularly deep neural network) becoming the method of choice for image processing and other computer vision tasks. A well-known example of a deep neural network trained for image recognition is AlexNet, (see "ImageNet Classification with Deep Convolutional Neural Networks", Advances in neural information processing systems, 2012, Alex Krizhevsky et al. - http://papers.nips.cc/paper/4824-imagenet-classification-with-deep-convolutional-neural-networks.pdf). Another suitable neural network is described in GoogLeNet (Szegedy, Christian, et al. "Going deeper with convolutions." Proceedings of the IEEE Conference on Computer Vision and Pattern Recognition. 2015)

Rule-based methods require writing of specialised code for each category of perforation, and this becomes unsustainable as the number of categories of perforation increases. Embodiments of the invention resolve this challenge and propose a different, generic approach, which is based on machine learning (the use of a neural network).

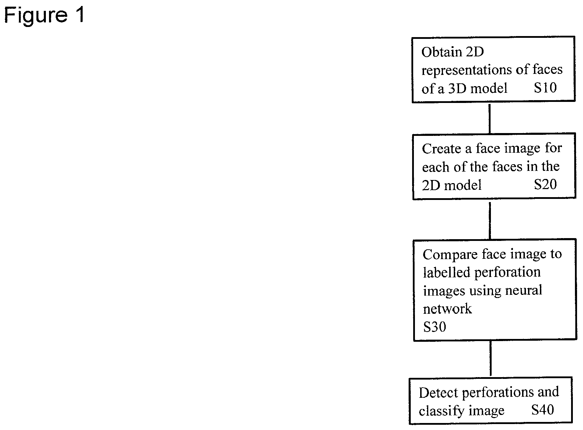

Figure 1 shows a general flowchart of a method of identifying a perforated face in a geometrical three-dimensional, 3D, model. Firstly, in S10, two-dimensional, 2D, representations of faces of the model are obtained. Not all the faces in the model are required in this process: some may be eliminated in advance by filtering, as explained in more detail later. In S20, a face image is created representing a rendering of each of the faces in 2D representation (using a rendering camera). This face image is then compared to labelled perforation images in a neural network in S30. Finally, in S40, the comparison is used to detect any perforations and to classify the face image as belonging to either a perforated or a non-perforated face.

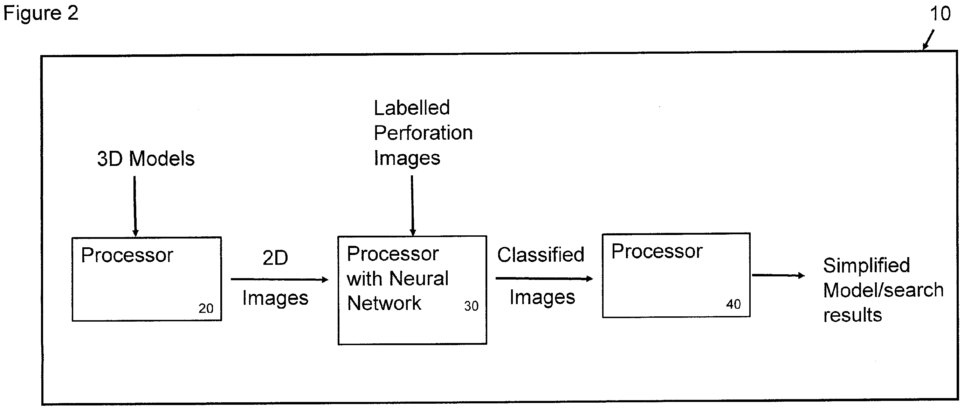

Figure 2 is a block diagram of information flow into main system components in apparatus 10. 3D models are processed by processor 20 to produce 2D images of model faces. These are compared to labelled images using a trained neural network which executes on processor 30 (which may be the same processor as processor 20) to classify the images. The classification is used in processor 40 (which may be the same as processor 20 and/or 30) to detect perforated faces and hence perforated parts.

For a given 3D part model (e.g. a component of an assembly model) invention embodiments may automatically determine following:
1. Is the component a perforated part (or part with perforated features), and optionally
2. What category of perforation is used in the perforated part?

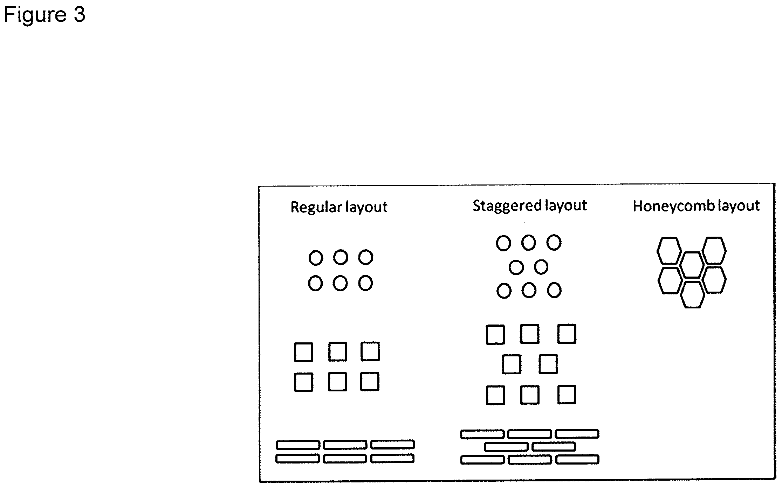

Unlike other 3D models, perforated part models are generally sheet models (i.e. basically 2D models with a third dimension that is tiny in relation to the other dimensions). There are many category of perforated sheets e.g. circle, diamond, honeycomb, etc. as illustrated in Figure 3. Both the shape/size of the perforations and their arrangement (i.e. grid, offset, random, interleaved) on the sheet may vary.

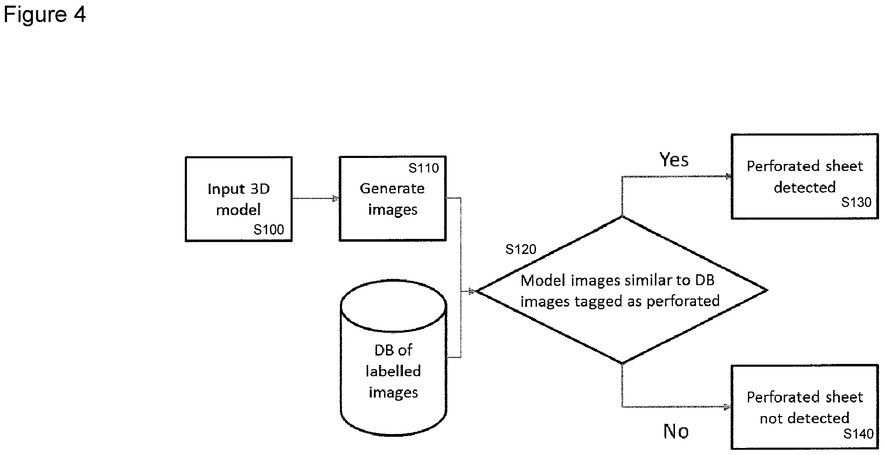

One aim is to determine whether a part has perforated features. In summary, this may be accomplished by comparing one or more images generated from each part to labelled images of perforated sheets stored in a database. The confidence that a region of the model is perforated may thus be proportional to the similarity of that region to other examples of perforated sheets stored in the database. An example of this process is shown in Figure 4.

The confidence level used to detect the perforations may be a user-defined parameter, dependent on application. A figure in the region of 50% would be the natural threshold (that is, more likely than not). However, it may be higher or lower depending of the business cost associated with a false positive and a false negative.

In step S100, the 3D model is input (e.g., to processor 20 in Figure 2). 2D Images (of the model faces) are generated from the model in S110. The images and a database of labelled images are compared in S120 (e.g., by processor 30 in Figure 2) and model images similar to database images are tagged as perforated and a perforated sheet (or other part) detected in S130, or not detected in step S140 (e.g., by processor 40 in Figure 2).

If a perforated part such as a sheet is detected, a second aim may be to determine the type of perforated sheet (e.g., also by processor 40 in Figure 2). This can be achieved by labelling different types of perforated sheets into separate classes defining different shapes and/or arrangements and/or sizes of perforation (e.g. diamond class, club class, honeycomb class etc.) by using the similarity of the model images with respect to these individual classes as represented in the database. Again, a suitable confidence level for detection of a particular type of perforation may be determined by the user, as set out above.

There may be the following benefits:
No coding is required for detection of new perforated patterns. This is an advantage compared to rule-based methods as disclosed e.g. EP2705450 (which explains a rule-based method for detection and simplification of perforated sheet CAD models)

The detection works even for triangulated data which represents shapes using a mesh - usually a multitude of triangles (e.g. STL data - STL (STereoLithography) is a file format native to the stereolithography CAD software created by 3D Systems or VRML data - VRML (Virtual Reality Modeling Language) is a standard file format for representing 3-dimensional (3D) interactive vector graphics, data). Rule-based systems usually require analytical CAD data, which defines shapes using mathematical functions.

The methodology allows precise classification of perforated sheets/parts into sub-categories and hence precise retrieval of similar sheets or precise use of analysis algorithms specific to a category of perforation.

The detection process can be used to categorise all the perforated features in a part model (for example into different categories of perforation)

### Detailed Description of Invention Embodiments

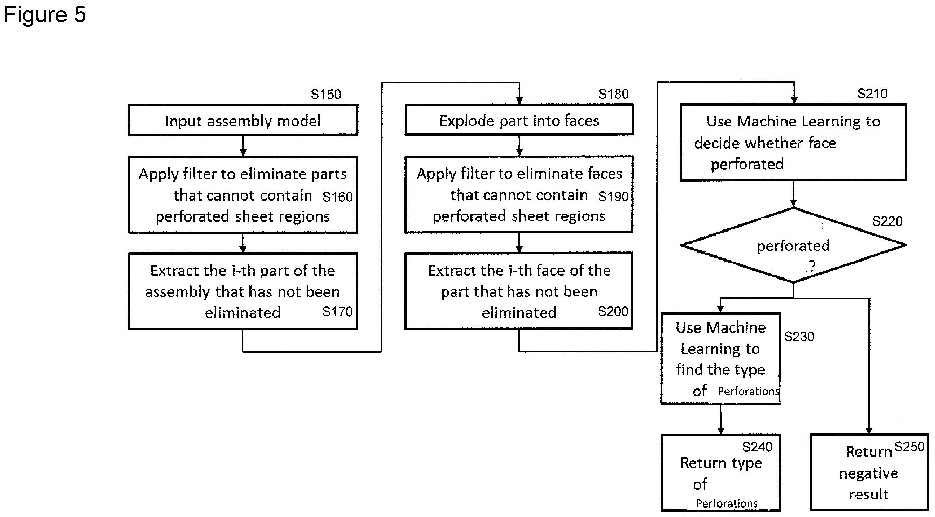

One flowchart of processing is shown in Figure 5. Figure 4 is an overview of the detection of perforated sheets, whereas Figure 5 shows details of processing in step 110 (which generates images) and in step S120 (which allows images to be tagged as perforated), including filtering steps to reducing processing cost by only processing parts and faces which may contain perforations.

The input to the system in step S150 is of an assembly model, which contains one or more parts.

A filter is applied in S160 to remove the parts that are judged (using a-priori knowledge) as not able to contain perforated sheets. Such a filter could be based on size, with components small enough (for example with a maximum bounding box dimension smaller than a give size, such as 1cm) being eliminated. In the case of an electronic product or other product which includes small connection parts, such a filter could automatically eliminate all small parts such as screws, connectors, plugs, etc.

Following this first filtration process, the system will advance to analyse all parts which have not been eliminated in S170, which takes the i-th part. This process is performed on a face-by-face basis, in which each face of each solid is analysed for perforated regions. Thus step S180 explodes the part into faces. Analogous to the filtration used for parts, a second filtration step S190 eliminates faces that cannot contain perforated regions using a-priori knowledge about the model. Such a filter could also be based on size. For example faces with an area small enough (for example with a maximum area smaller than 1cm²) could be automatically eliminated. Any face not eliminated is extracted in S200.

Following this second filtration process, the system will advance to analyse all faces which have not been eliminated in S210. This analysis is done using a method based on machine learning and thus based on the use of a neural network (as opposed to the conventional systems that use rules) to divide between perforated faces (referred to as sheets) in S220. If the analysis returns a positive result (meaning that the face contains at least one perforated region), a second analysis step in S230 (again based on machine learning and the use of a neural network) is used to assess the type of perforation and the type of perforation is returned in S240. If the result is negative, the system will flag that face as not containing any perforated sheet regions in S250. Subsequently, parts that contain at least one face that contains at least one perforated region are labelled as parts containing perforated regions.

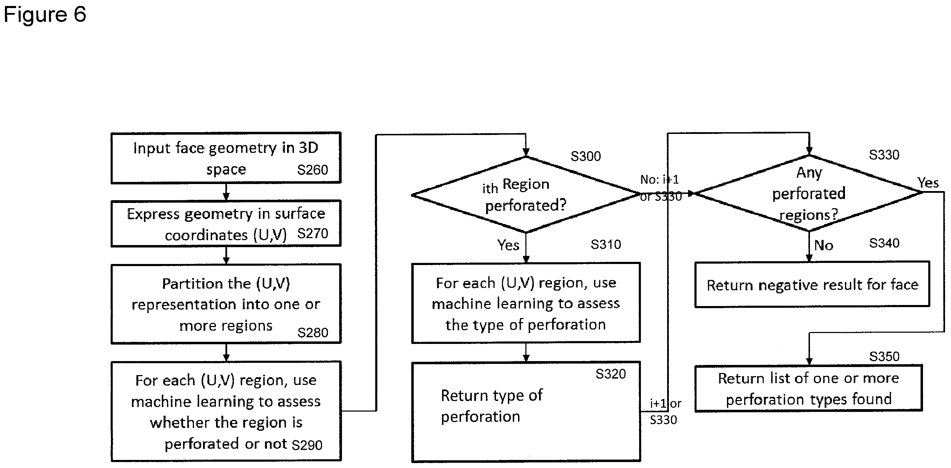

The process for analysing each face not eliminated by the two filters is shown in Figure 6. This process hence takes place after the i-th face has been extracted and can replace general steps S210 to S250 when a face is divided into regions.

After input of 3D geometry in S260, the original 3D presentation in Cartesian coordinates (X, Y, Z) is converted to a 2D representation in surface coordinates in S270. For analytical CAD data such a representation is readily provided by the CAD kernel being used. For example, the OpenCASCADE CAD kernel provides a "Geom_Surface" representation for a CAD face, which is expressed in surface coordinates. In this representation, the boundaries of the surface can be retrieved using the function "Bounds" which returns the start and end values for U and V.

In the case of triangulated data, in which a face is define by a collection of triangles sharing the same Face ID, such a representation could be extracted via fitting to an analytical function, such as those employed by remeshing algorithms (see for example "Optimal parametrizations for surface remeshing" Marchandise et al. http://qmsh.info/doc/preprints/gmsh stl3 preprint.pdf).

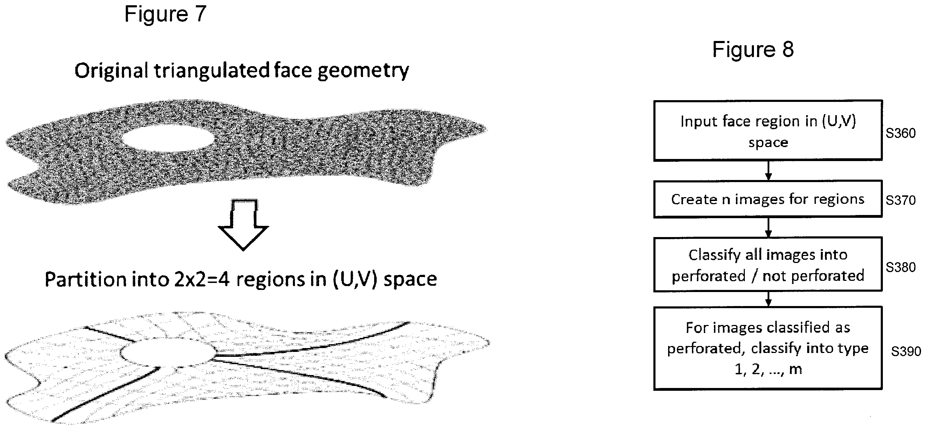

Once the bounds for the (U, V) surface coordinates have been found, the face is partitioned into 1 or more partitions in S280, along the U, V or both coordinates. The partitioning need not take place, for example for smaller faces, but a decision as to partitioning is made at this point. The decision on how to split would in general be made by considering the size of the face. An example of such a partitioning is shown in Figure 7, in which a triangulated surface is partitioned into 4 regions. Each region of the face may then be independently analysed in S290 using a machine learning/neural network method. If the method returns that the region is perforated in S300, a subsequent step S310 is performed in order to find the type of perforation. After all regions of the face have been processed in S320, the following 2 outputs in S330 are possible:
- The face does not contain any perforated regions, in which case no region of the face is perforated and a negative result is returned for the face in S340
- A list of one or more types of perforations in S350, in which case one or more regions are labelled as perforated.

Each region obtained at the previous step is analysed and classified. The approach taken for classification is an image based approach, as shown in Figure 8. After input of the region in surface coordinates in S360, one or more images representing renderings of the geometry of the region are created from the geometrical information in S370. Each image is classified in S380, using supervised machine learning algorithms known in the art which have been trained to classify images into perforated / non-perforated using a neural network. An example of a state-of-the-art algorithm that can be used for such purpose is a retrained convolutional neural network, such as AlexNet (mentioned earlier), that has been tuned on a collection of labelled images of various types of perforated and non-perforated sheets. For images classified as perforated, a similar supervised machine learning algorithm in a neural network can be used in S390 to classify the perforation pattern into a number of known patterns (or these two steps may be taken together). The region will be classified as perforated if at least one image generated from that region is classified as perforated.

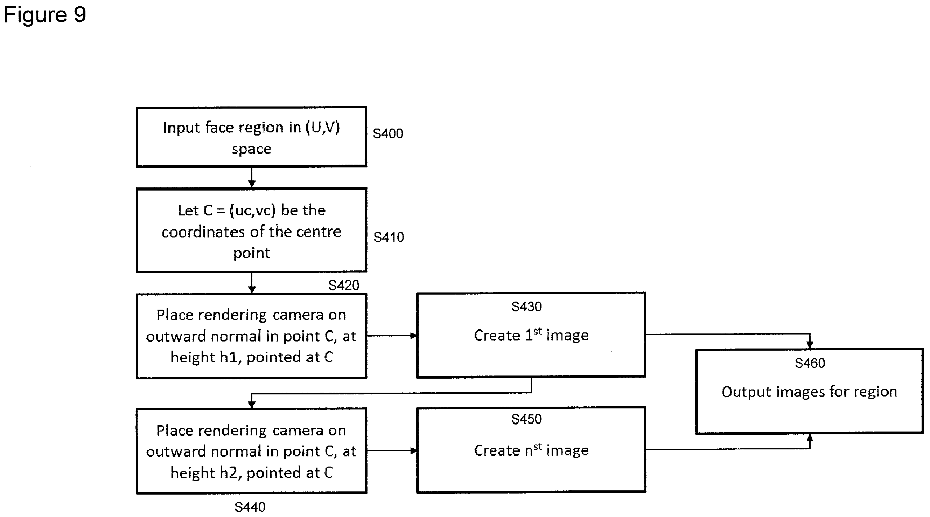

Finally, the process for creating images from the geometry of an image is shown in Figure 9. After input of the region in surface coordinates in S400, in step S410, C is defined as the centre of the region as expressed in (u,v) coordinates and the nC is defined as the outward normal to the region surface passing through C. Using standard techniques available in off-the-shelf CAD packages and rendering packages, a rendering (notional) camera (which saves 3D views of an object from a defined viewpoint) is positioned in step S420 on the normal nC, at distance (height h1) from the surface and pointing to point C. The choice of h1 is such that the entire region can fit in the field of view of the camera. Using this rendering camera, we generate the 1^{st} image for the region in S430.

To account for the fact that perforations can have different sizes, a second, closer camera may be placed in S440 at height h2, between h1 and point C and a 2^{nd} (zoomed-in) image can be generated in S450 as well. This process can be repeated to generate more images by zooming in and out (hence the reference to the nth image in S450).

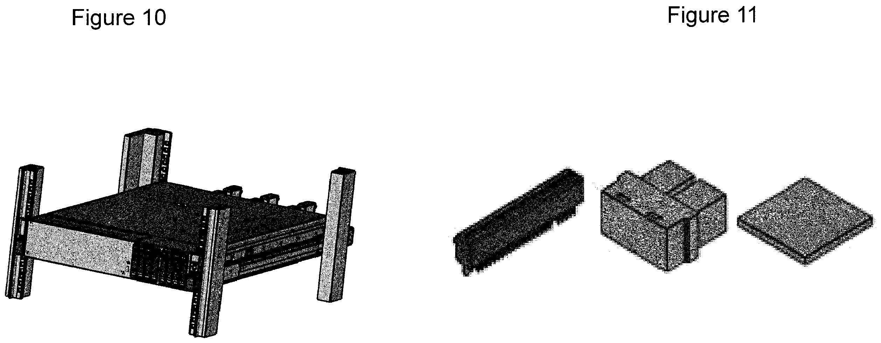

Consider the server model shown in the Figure 10 example as input to the system. The server is an assembly model with more than 1000 parts. A first filtration step eliminates all parts with a bounding box smaller than 3cm. This filtration removes small parts such as connectors or screws that are known not to contain perforations. Examples of components eliminated at this step are shown in Figure 11.

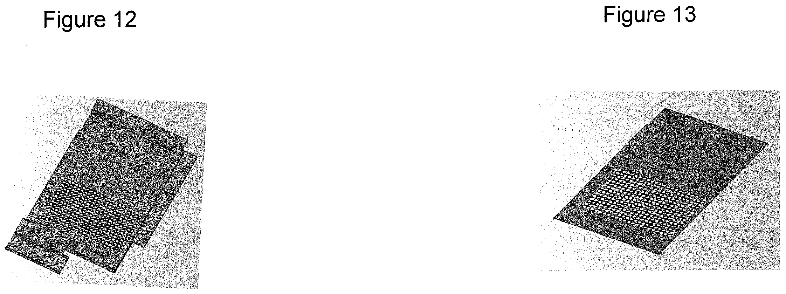

All parts left after the first filtration process (now a few hundred) are to be processed further. As an example, the part shown in Figure 12 is processed.

The part in Figure 12 contains 845 CAD faces, which is a very large number. However, the large majority of faces are very small or very thin, hence cannot contain perforated regions. After running the 2^{nd} filter which is set to remove faces that do not have at least two dimensions larger than 1 cm, less than 20 faces are left. All of these faces are analysed in the next step.

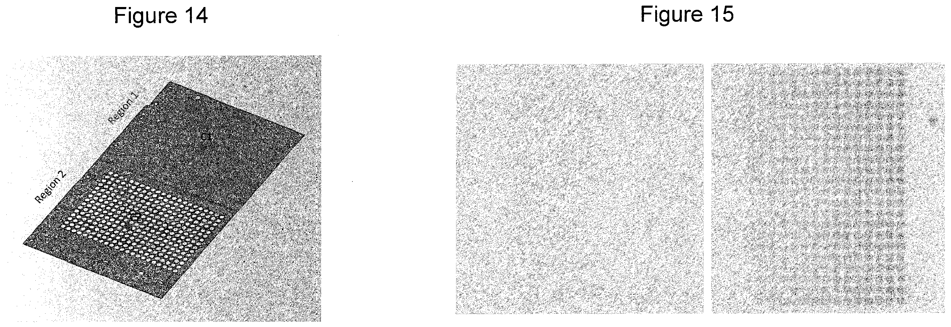

For example, analysis is carried out of the face shown in Figure 13. Based on its size, the face may be divided into 2 regions, as shown in Figure 14. Cameras are placed on the outward normal direction from the centres of the regions (denoted C1 and C2) and pointing to C1 and C2, respectively. The cameras are placed in such a way that the entire region will enter the field of view.

Rendering from the two cameras will generate image 1 and image 2 that correspond to regions 1 and 2 respectively. These are shown in Figure 15. Subsequently, a pretrained AlexNet tuned on perforated images will classify the 1^{st} image as non-perforated and 2^{nd} image as perforated. Furthermore, the 2^{nd} image is classified as round perforated.

### Removal of Perforations

A preferred method of removing a group of perforations in a geometric model uses bounding boxes around each of the detected perforations/through holes, as described in more detail in EP2705450. This method may be used in two dimensions, which simplifies the processing.

A separate bounding box surrounding each through hole in a set of through holes is provided; the volume (or area for a 2D bounding box used on an image) of each separate bounding box is calculated; and the size of each separate bounding box is increased by an offset factor, which adjusts the highest and lowest extent of the bounding boxes equally and oppositely in at least one of the mutually perpendicular x, y and z directions (or u and v directions). Such a scaling factor is not dependent on the original size of the bounding box.

The offset factor makes at least two of the separate bounding boxes overlap; then a united set of all the bounding boxes is created, overlapping separate bounding boxes becoming a single combined bounding box; the size of each bounding box in the united set is reduced by the scaling factor; and the one or more individual bodies formed by the one or more reduced-size bounding boxes are extracted from the united set, each individual body potentially representing a group of perforations.

Replacement with a porous replacement portion can take place after detection.

This methodology can group together separate through holes in an array (perforations) by using the adjacent location but without any kind of iterative searching process. The method uses offsetting of (scaling of) the size of the bounding-box and unite and extract operations (both sometimes referred to as Boolean operations) to achieve the required result. The process can be the same for any kind of perforated shape and pattern of perforations.

Boolean operations as used in CAD applications are operations on sets which are known to the skilled person, such as the union operation, the intersection operation and the difference operation. Extraction reverses the union operation to separate the individual bodies in a united set, so that they can be treated individually.

In preferred embodiments, if at least the volume of the through holes in the set is the same (to within normal error margins) of if a single bounding box volume is provided despite any differences in volume/shape of the through holes, then the step of calculating the volume of each separate bounding box may include only calculating the volume of one bounding box and using this volume for each separate bounding box.

The numerical value of the offset factor can be set at a default value and/or set by user input. The user input may be at the start of the method or during the method if the previous scaling factor was not sufficient to join adjacent bounding boxes to provide at least one single combined bounding box.

The scaled-back individual bodies will either correspond to a combined bounding box including two or more perforations, or to a separate bounding box which has not been combined with any others in the unite step because it did not overlap with any other bounding boxes. This latter category of individual bodies may be removed by comparing with an original volume to deselect individual bodies. If each separate bounding box starts with the same volume, the comparison is just against the known original volume of all the bounding boxes. If the original separate bounding boxes have different volumes, the comparison can be against an average volume, against the smallest volume of an original separate bounding box, against the largest volume of an original separate bounding box or against the volume of the original separate bounding box which has been scaled up and resized back to the original size. The skilled reader will appreciate that the comparison may take into account an error margin.

Once the individual bodies (or remaining individual bodies) are available, the next stage is to provide them with a porosity value so that they are equivalent to the perforations they are to replace. The method may include deriving or at least using a porosity for each (remaining) individual body to provide a porosity equivalent to the combined effect of the individual perforations in an identified group of perforations.

It may be that the processing has stored the number, and if necessary also the volume, of holes and that this volume can be allocated to individual bodies. This may well be true, for example, if the uniting operation has created a single individual body from the set of through holes and thus a single group of perforations has been identified. In that case, it should be possible to derive porosity using this information. However, in other circumstances, the Boolean union operation can mean that there is no longer a link between the through holes and the individual bodies. In these circumstances, a temporary body may be created for each individual body, for the purposes of porosity calculation only, by Boolean intersection of the individual body with the part model. This temporary part is thus identical in size, position and shape to the individual body but its volume is reduced by the group of perforations. The porosity of the individual body may be derived by then using a ratio between the volume of the individual body and the volume of the temporary part. The ratio value may be, for example, 1.0 - (volume of the temporary part/volume of the individual body).

Subsequently, the temporary body is discarded.

Once the individual body has been given the calculated porosity that provides an equivalent airflow to the perforations within the previously included volume taken up by individual body, the processing is complete. In some systems, it may be that a specific step is required for this final outcome, in others the individual body which has already been defined will have automatically replaced the corresponding portion of the geometric model and thus removed the through holes.

In a preferred embodiment, the individual body is already present in the model (once it has been derived) and a final replacement step removes the perforations, for example by Boolean subtraction. This Boolean subtraction may remove the portion of the original model which intersects with each individual body.

### Hardware

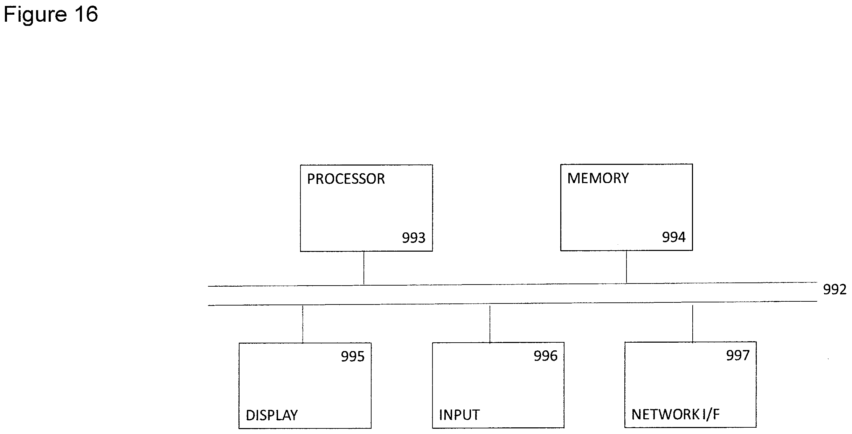

Figure 16 is a block diagram of a computing device, such as a server incorporating resources suitable for CAD model processing, which embodies the present invention, and which may be used to implement a method of perforation detection and optionally removal, as well as any CAE analysis required. The computing device comprises a processor 993, and memory, 994. Optionally, the computing device also includes a network interface 997 for communication with other computing devices, for example with other computing devices of invention embodiments.

For example, an embodiment may be composed of a network of such computing devices. Optionally, the computing device also includes one or more input mechanisms such as keyboard and mouse 996 for the user to input any of, for example, search parameters to search for particular perforations, parts which may contain perforations or process variables, and a display unit such as one or more monitors 995. The display unit may show a representation of data stored by the computing device for instance, representations of sheets in which perforations have been identified, or removed, or a visualisation of a CAE simulation. The display unit 995 may also display a cursor and dialog boxes and screens enabling interaction between a user and the programs and data stored on the computing device. The input mechanisms 996 may enable a user to input data and instructions to the computing device. The components are connectable to one another via a bus 992.

The memory 994 may include a computer readable medium, which term may refer to a single medium or multiple media (e.g., a centralized or distributed database and/or associated caches and servers) configured to carry computer-executable instructions or have data structures stored thereon. Computer-executable instructions may include, for example, instructions and data accessible by and causing a general purpose computer, special purpose computer, or special purpose processing device (e.g., one or more processors) to perform one or more functions or operations. Thus, the term "computer-readable storage medium" may also include any medium that is capable of storing, encoding or carrying a set of instructions for execution by the machine and that cause the machine to perform any one or more of the methods of the present disclosure. The term "computer-readable storage medium" may accordingly be taken to include, but not be limited to, solid-state memories, optical media and magnetic media. By way of example, and not limitation, such computer-readable media may include non-transitory computer-readable storage media, including Random Access Memory (RAM), Read-Only Memory (ROM), Electrically Erasable Programmable Read-Only Memory (EEPROM), Compact Disc Read-Only Memory (CD-ROM) or other optical disk storage, magnetic disk storage or other magnetic storage devices, flash memory devices (e.g., solid state memory devices).

The processor 993 is configured to control the computing device and execute processing operations, for example executing code stored in the memory to implement the various different functions described here and in the claims. Such processing operations include obtaining two-dimensional, 2D, representations of faces of the model, creating a face image representing a rendering of each of the faces in 2D representation, comparing the face image to labelled perforation images in a neural network; and using the comparison to detect any perforations and classify the face image as belonging to one of: a perforated and a non-perforated face.

The memory 994 stores data being read and written by the processor 993, such as the inputs (for example labelled images or images for training the neural network and 3D models), interim results (such as face images) and results of the processes referred to above (such as classification of faces and parts). As referred to herein, a processor may include one or more general-purpose processing devices such as a microprocessor, central processing unit, or the like. The processor may include a complex instruction set computing (CISC) microprocessor, reduced instruction set computing (RISC) microprocessor, very long instruction word (VLIW) microprocessor, or a processor implementing other instruction sets or processors implementing a combination of instruction sets. The processor may also include one or more special-purpose processing devices such as an application specific integrated circuit (ASIC), a field programmable gate array (FPGA), a digital signal processor (DSP), network processor, or the like. In one or more embodiments, a processor is configured to execute instructions for performing the operations and steps discussed herein.

The network interface (network I/F) 997 may be connected to a network, such as the Internet, and is connectable to other such computing devices via the network. The network I/F 997 may control data input/output from/to other apparatus via the network. Other peripheral devices such as microphone, speakers, printer, power supply unit, fan, case, scanner, trackerball etc. may be included in the computing device.

Methods embodying the present invention may be carried out on a computing device such as that illustrated in Figure 16, Such a computing device need not have every component illustrated in Figure 16 and may be composed of a subset of those components. A method embodying the present invention may be carried out by a single computing device in communication with one or more data storage servers via a network. The computing device may be a data storage itself storing the CAD models before and after processing and thus for example, with parts classified as perforated and also potentially with and without perforations, for analysis.

A method embodying the present invention may be carried out by a plurality of computing devices operating in cooperation with one another. One or more of the plurality of computing devices may be a data storage server storing at least a portion of a CAD model.

Other hardware arrangements, such as laptops, iPads and tablet PCs in general could alternatively be provided. The software for carrying out the method of invention embodiments as well as labelled images, a CAD data file and any other file required may be downloaded, for example over a network such as the internet, or using removable media. Any modified CAD file can be stored, written onto removable media or downloaded over a network.

The invention embodiments can be applied to any field that requires classification and query for 3D data involving perforated models. Examples are mechanical design (e.g. automotive and computer), 3D printing, etc.

### Neural Network

Artificial neural networks are widely employed to perform pattern matching and diagnostic procedures, using so-called "machine learning". A typical structure of an artificial neural network is a three-layer structure, having an input layer at which observations are input to the network, a hidden or processing layer, at which further processing operations are carried out on information received from the input layer, and an output layer, at which an output signal is generated based on information received from the processing layer. The precise structure of the artificial neural network is not limited, neither are the specific functions of the layers.

A suitable neural network system can include a training processor which utilises test data and annotated data to generate a trained model for perforation detection, which trained model is accessible by a detection processor. Detection is performed with reference to a similarity value computation processor.

Such a system comprises a hardware architecture such as that illustrated in Figure 16 (described above), which may be the same as that used for the CAD processing steps, or different architecture, but linked to the CAD processing architecture via network interface 997 for input of face images and output of labelled/classified face images.

In particular, processor 993 performs the processing instructions of the training processor, the detection processor, and the similarity value computation processor. One or more storage units (memories) 994 store the processing instructions, the trained model for perforation detection, the face image data, the test data and annotated data in the form of labelled images of perforated and non-perforated sheets.

A training apparatus is configured to perform a training process. The training apparatus is under the control of the training processor, and is configured to store test data, annotated data, and a model that is being trained in memory 994.

Once the training processing is complete, a trained image classification convolutional neural network model is obtained, which can be applied directly to image data by the detection processor. Such direct application can be referred to as forward propagation.

For example, the model being trained may be an image classification convolutional neural network model.

The network used may be a classification network, in which the training set receives images, each with a label (which is usually encoded as a natural number). In a simple example, the input data might be input in the following format, or a similar format:
Img1.jpg 0
Img2.jpg 0
Img3.jpg 1
Img4.jpg 1
0 might be "round perforated sheet" (a sheet with circular perforations) and 1 could be "square perforated sheet" (a sheet with square perforations).

Given an unseen image, the network can compute the probability of it belonging to a certain class (perforated or non-perforated) and a certain category (for example round or square perforations). A final layer of the network can be used to extract feature vectors and use these vector to compute the similarity between multiple images (e.g., by computing the cosine similarity).

The images may be stored in memory 994 as raw image files (i.e. pixel value by pixel value) or stored in an image format such as tiff, jpeg, or bitmap.

An image classification neural network model such as LeNet or AlexNet could be stored as the image classification convolutional neural network model and trained by the training processor. As the input image data is normally large in size, convolutional neural network models may effectively perform dimension reduction, reducing the input image data to a single vector of feature values per image, representing key features of the image representation.

### Benefits of invention embodiments

An important benefit of invention embodiments is that new categories of perforation can be dynamically added (by adding to the images used to train the CNN) without coding or modification (this can be referred to as the endless case of capability expansion).

As mentioned above, the method works for both CAD and triangulated data e.g. STL and VRML

Invention embodiments allow perforated models to be classified into sub-categories, thus differentiating between types of perforation and providing more precision in classification, giving the type of perforation e.g. circular, diamond, hexagon, etc., especially for parts with multiple perforated patterns.

It is therefore possible to retrieve similar category models (having sheets with the same or similar type of perforation) using a query search system of main classification e.g. perforated or not and sub-classification e.g. circle only or multiple pattern.

## Claims

1. A computer-implemented method of identifying a perforated face in a geometrical three-dimensional, 3D, model, the method comprising:
obtaining two-dimensional, 2D, representations of faces of the model;
creating a face image representing a rendering of each of the faces in 2D representation;
comparing the face image to labelled perforation images in a neural network; and
using the comparison to detect any perforations and classify the face image as belonging to one of: a perforated and a non-perforated face.

2. A method according to claim 1, further comprising:
categorising the geometrical type and/or arrangement of perforations of a perforated face in the neural network.

3. A method according to claim 1 or 2, further comprising:
selecting any part in the model including a face classified as perforated; and
optionally retrieving any of part geometry, part manufacturing cost, part delivery time and part identification.

4. A method according to claim 1, 2 or 3, wherein:
for a model with triangulated CAD data, the 2D representations are created via fitting to an analytical function; and
for a model with analytical CAD data, the 2D representations are provided by a CAD kernel.

5. A method according to any of the preceding claims, wherein:
the model includes parts and a part filter eliminates parts that are unsuited to including perforated regions before any 2D images of faces are obtained.

6. A method according to any of the preceding claims, wherein:
a face filter eliminates faces that are unsuited to including perforated regions before any 2D images of faces are obtained.

7. A method according to any of the preceding claims, wherein:
an original face image is partitioned into face region images which are compared to the labelled perforation images, and preferably wherein:
a face region corresponding to a face region image which is classified as perforated is replaced by a solid face region by removing the perforations.

8. A method according to any of the preceding claims, wherein:
a face image is taken by a rendering camera from a position along the normal to the centre of the face image where the entire face image fits into the field of view of the camera.

9. A method according to claim 7, wherein:
a further face image is taken at a different position along the normal to capture perforations of a different size.

10. A computer-implemented method according to any of the preceding claims, the method further comprising:
simplifying the geometrical three-dimensional, 3D, model including perforations, by, for a perforated face identified by classification of the face image, replacing the face in the 3D model with a solid face by removing the perforations.

11. A method according to any of the preceding claims, wherein:
the solid face is given a porosity value in place of the perforations.

12. A computer-implemented method of analysing a geometrical three-dimensional, 3D, model including carrying out the method of claim 9, 10 or 11 and then analysing the simplified model using a numerical technique to determine physical results of the model shape, such as thermal, mechanical, or electro-magnetic properties, or airflow around and/or through the model.

13. An apparatus configured to identify a perforated face in a geometrical three-dimensional, 3D, model, the apparatus comprising one or more processors and a memory, the one or more processor configured to:
obtain two-dimensional, 2D, representations of faces of the model;
create a face image representing a rendering of each of the faces in 2D representation;
compare the face image to labelled perforation images stored in the memory using a neural network; and
use the comparison to detect any perforations and to classify the face image as belonging to one of: a perforated and a non-perforated face.

14. A computer program which when executed carries out a computer-implemented method of identifying a perforated face in a geometrical three-dimensional, 3D, model, the method comprising:
obtaining two-dimensional, 2D, representations of faces of the model;
creating a face image representing a rendering of each of the faces in 2D representation;
comparing the face image to labelled perforation images in a neural network; and
using the comparison to detect any perforations and classify the face image as belonging to one of: a perforated and a non-perforated face.

15. A non-transitory computer-readable medium storing a computer program according to claim 14.
